# EUROPÄISCHE PATENTSCHRIFT

(11) **EP 2 792 014 B1**
(45) Veröffentlichungstag und Bekanntmachung des Hinweises auf die Patenterteilung: **06.01.2021**
(21) Anmeldenummer: 12798191.8
(22) Anmeldetag: 15.11.2012
(51) Int. Cl.: H01M 10/48, H01M 10/42, H04B 5/00, H04Q 9/00

(54) **VORRICHTUNG UND VERFAHREN ZUM ÜBERTRAGEN EINER INFORMATION AUS EINER BATTERIEZELLE UND BATTERIEZELLE**
DEVICE AND METHOD FOR TRANSMITTING AN INFORMATION ITEM FROM A BATTERY CELL AND BATTERY CELL
DISPOSITIF ET PROCÉDÉ DE TRANSMISSION D'UNE INFORMATION PROVENANT D'UN ÉLÉMENT DE BATTERIE ET ÉLÉMENT DE BATTERIE

(30) Priorität: 14.12.2011 DE 102011088530
(43) Veröffentlichungstag der Anmeldung: 22.10.2014
(73) Patentinhaber: Robert Bosch GmbH, 70442 Stuttgart (DE)
(72) Erfinder: SCHUMANN, Bernd, 71277 Rutestein (DE); HENRICI, Fabian, 70195 Stuttgart (DE)
(86) Internationale Anmeldenummer: PCT/EP2012/072681
(87) Internationale Veröffentlichungsnummer: WO 2013/087339

(56) Entgegenhaltungen:
- WO-A1-2005/078673
- DE-A1-102007 021 921
- DE-A1-102007 063 188
- DE-A1-102007 063 280
- DE-A1-102009 045 887
- DE-U1-202008 001 113
- US-A1- 2009 027 228

## Beschreibung

### Stand der Technik

Die vorliegende Erfindung bezieht sich auf eine Vorrichtung zum Übertragen einer Information aus einer Batteriezelle, auf eine Batteriezelle zum Speichern elektrischer Energie und auf ein Verfahren zum Übertragen einer Information aus einer Batteriezelle.

Die DE 10 2007 021 921 A1 beschreibt eine Vorrichtung zum Überwachen eines Batteriespeichers. Die WO 2005/078673 A1 offenbart eine Batteriezelle zum Speichern elektrischer Energie, mit einer Vorrichtung zum Übertragen einer Information aus der Batteriezelle.

### Offenbarung der Erfindung

Vor diesem Hintergrund werden mit der vorliegenden Erfindung eine Vorrichtung zum Übertragen einer Information aus einer Batteriezelle, eine Batteriezelle zum Speichern elektrischer Energie und ein Verfahren zum Übertragen einer Information aus einer Batteriezelle gemäß den Hauptansprüchen vorgestellt. Vorteilhafte Ausgestaltungen ergeben sich aus den jeweiligen Unteransprüchen und der nachfolgenden Beschreibung.

In einer Batteriezelle kann eine Elektronik, beispielsweise in Form eines Sensors angeordnet werden, die mit einer weiteren, außerhalb der Batteriezelle angeordneten weiteren Elektronik kommunizieren kann. Dazu ist eine Übertragung eines Signals durch eine Batteriewand hindurch in die Batterie hinein oder aus der Batterie heraus erforderlich. Wird das Signal direkt durch die Batteriewand übertragen, das heißt, ohne dass durch die Batteriewand eine Leitung zum Übertragen des Signals geführt wird, so kann auf ein Loch in der Batteriewand verzichtet werden. Dadurch besteht keine Gefahr, dass die Batterie undicht werden kann. Auch kann auf teure Durchführungen durch die Zellwand der Batterie verzichtet werden. Dadurch können Herstellungskosten für die Batteriezelle gesenkt werden und die Dichtigkeit der Batterie kann verbessert werden.

Eine Vorrichtung zum Übertragen einer Information aus einer Batteriezelle weist folgende Merkmale auf:
einen ersten Übertrager, der auf einer Innenseite einer Außenhülle der Batteriezelle angeordnet ist, wobei der erste Übertrager dazu ausgebildet ist, ein, die Information repräsentierendes Signal durch die Außenhülle abzugeben; und
einen zweiten Übertrager, der auf einer Außenseite der Außenhülle angeordnet ist und galvanisch von dem ersten Übertrager getrennt ist, wobei der zweite Übertrager dazu ausgebildet ist, das Signal aufzunehmen.

Unter einem Übertrager kann ein Sender oder ein Empfänger oder eine Sende-Empfangs-Einrichtung verstanden werden. Der erste Übertrager und der zweite Übertrager können gleich ausgebildet sein. Eine Außenhülle kann eine Begrenzung der Batteriezelle sein. Die Außenhülle kann die Batteriezelle vollständig umschließen. Die Außenhülle kann eine äußere Wand der Batteriezelle darstellen. Eine Information kann Daten repräsentieren, die beispielsweise im Inneren der Batteriezelle erfasst und an eine außerhalb der Batteriezelle angeordnete Einrichtung zu übertragen sind. Beispielsweise kann die Information einen Messwert eines in der Batteriezelle angeordneten Sensor repräsentieren. Auch kann die Information einen Betriebszustand der Batteriezelle widerspiegeln. Beispielsweise kann die Information Werte eines Temperatursensors, eines Spannungsmessgeräts oder eines chemischen Analytiksensors umfassen. Der zweite Übertrager kann einen entsprechenden Sensor umfassen oder mit einem entsprechenden Sensor gekoppelt sein. Die Information kann unter Verwendung eines Kommunikationsprotokolls in das Signal überführt werden. Die Übertrager können direkt an der Außenhülle befestigt sein. Die Übertrager können in einem Abschnitt der Außenhülle gegenüberliegend angeordnet sein. Galvanisch getrennt kann so verstanden werden, dass die Übertrager nicht über eine elektrische Leitung miteinander verbunden sind. Insbesondere ist der erste Übertrager ausgebildet, um das Signal nicht leitungsgebunden abzugeben. Auf diese Weise kann die Information in die Batteriezelle hinein übertragen werden, ohne dass ein Durchgangsloch in der Außenhülle erforderlich ist, durch das eine zwischen den Übertragern verlaufende Signalleitung geführt ist. Die Übertrager können gegenüber der Außenhülle elektrisch isoliert sein.

Der zweite Übertrager ist dazu ausgebildet, ein eine weitere Information repräsentierendes, weiteres Signal durch die Außenhülle abzugeben. Der erste Übertrager ist dazu ausgebildet, das weitere Signal aufzunehmen. Auf diese Weise kann die weitere Information in die Batteriezelle hinein übertragen werden. Eine weitere Information kann beispielsweise ein Steuerbefehl für den ersten Übertrager oder für einen Sensor in der Batteriezelle sein. Auf diese Weise ist über die Übertrager eine bidirektionale Kommunikation möglich.

Der erste Übertrager ist unmittelbar an der Außenhülle angeordnet. Ergänzend dazu ist der zweite Übertrager unmittelbar an der Außenhülle angeordnet.

Durch eine unmittelbare Anordnung der Übertrager an der Außenhülle kann das Signal mit geringen Verlusten durch die Außenhülle gesendet werden. Auch kann die Außenhülle als mechanischer Träger der Übertrager dienen.

Der erste Übertrager kann einen auf die Außenhülle gerichteten ersten Übertragungsbereich aufweisen. Der zweite Übertrager kann innerhalb des ersten Übertragungsbereichs angeordnet sein. Alternativ oder ergänzend kann der zweite Übertrager einen auf die Außenhülle gerichteten zweiten Übertragungsbereich aufweisen. Der erste Übertrager kann innerhalb des zweiten Übertragungsbereichs angeordnet sein. Die Übertrager können eine Richtcharakteristik aufweisen, um das Signal gezielt durch die Außenhülle zu übertragen. Die Übertrager können einander gegenüberliegend an der Außenhülle angeordnet sein.

Der erste Übertrager und der zweite Übertrager können je als ein induktiver Übertrager ausgebildet sein. Zumindest einer der Übertrager kann als Spule ausgebildet sein. Der andere Übertrager kann als Dipol oder Spule ausgebildet sein. Der zweite Übertrager kann auch als Teilstück eines Kabels ausgebildet sein. Dann können mehrere Informationen mehrerer Batteriezellen mit einem Kabel aufgenommen werden. Die Signale können codiert sein.

Der erste Übertrager und der zweite Übertrager können je als ein kapazitiver Übertrager ausgebildet sein. Je ein Übertrager kann eine Platte eines Plattenkondensators sein. Eine Ladungsverschiebung im ersten Übertrager kann eine Ladungsverschiebung im zweiten Übertrager hervorrufen, und umgekehrt.

Eine Batteriezelle zum Speichern elektrischer Energie weist die folgenden Merkmale auf:
eine Außenhülle, die die Batteriezelle umschließt; und
eine Vorrichtung zum Übertragen, die an der Außenhülle angeordnet ist.

Die Außenhülle kann beispielsweise eine metallische Wand sein. Auch kann die Außenhülle aus Kunststoff sein. Durch die Außenhülle können elektrische Anschlüsse der Batteriezelle geführt sein. Die Batteriezelle kann beispielsweise in einem Fahrzeug als Teil einer wiederaufladbaren Batterie eingesetzt werden.

Die Außenhülle kann eine Berstmembran aufweisen. In diesem Fall kann die Vorrichtung im Bereich der Berstmembran angeordnet sein. Eine Berstmembran kann durch eine Volumenveränderung im Inneren der Batteriezelle plastisch verformt werden. Bei Überschreiten einer vorbestimmten Volumenveränderung kann die Berstmembran kontrolliert versagen, und so die angrenzende Außenwand der Batterie vor einer Beschädigung schützen. Die Berstmembran kann eine geringere Widerstandskraft aufweisen, als die angrenzende Außenwand. Somit kann eine Außenwand der Batteriezelle aus einem ersten Wandmaterial bestehen, in dem eine Aussparung mit der Berstmembran aus einem zweiten Wandmaterial angeordnet ist. In diesem Fall wird die Außenhülle aus einer Außenwand gebildet, die eine Aussparung aufweist, die von der Berstmembran überspannt wird.

Die Außenhülle kann im Bereich der Vorrichtung elektrisch isolierend sein. Elektrisch isolierendes Material kann eine Übertragung zwischen den Übertragern wenig oder gar nicht stören. Durch elektrisch isolierendes Material, wie Kunststoff oder Keramik kann das Signal unverfälscht und unmittelbar übertragen werden. Die Außenhülle kann im Bereich der Vorrichtung elektrisch leitend sein. Die Außenhülle kann mit dem Signal interagieren und beispielsweise eine Impulsorientierung des Signals umkehren. Die Außenhülle kann von dem ersten Übertrager und dem zweiten Übertrager elektrisch isoliert sein, sodass beispielsweise eine Ladungsverschiebung in dem ersten Übertrager zu Ladungsverschiebungen in der Außenhülle und damit zu Ladungsverschiebungen in dem zweiten Übertrager führen kann. Ebenso kann der erste Übertrager Wirbelströme in der Außenhülle induzieren, die wiederum einen Strom in dem zweiten Übertrager induzieren.

Ein Verfahren zum Übertragen einer Information aus einer Batteriezelle weist die folgenden Schritte auf:
Abgeben eines die Information repräsentierenden Signals mittels einem auf einer Innenseite einer Außenhülle der Batteriezelle angeordneten ersten Übertrager, wobei das Signal dazu ausgebildet ist, um die Außenhülle zu durchdringen; und
Aufnehmen des Signals mittels einem auf einer Außenseite der Außenhülle angeordneten zweiten Übertragers.

Die Erfindung wird nachstehend anhand der beigefügten Zeichnungen beispielhaft näher erläutert. Es zeigen:
- Fig. 1: eine Darstellung einer Batteriezelle mit einer Vorrichtung zum Übertragen einer Information gemäß einem Ausführungsbeispiel der vorliegenden Erfindung;
- Fig. 2: eine Darstellung einer weiteren Batteriezelle mit einer Vorrichtung zum Übertragen einer Information gemäß einem weiteren Ausführungsbeispiel der vorliegenden Erfindung;
- Fig. 3: eine Darstellung einer weiteren Batteriezelle mit einer Vorrichtung zum Übertragen einer Information gemäß einem Ausführungsbeispiel der vorliegenden Erfindung;
- Fig. 4: eine Darstellung einer weiteren Batteriezelle mit einer Vorrichtung zum Übertragen einer Information gemäß einem Ausführungsbeispiel der vorliegenden Erfindung; und
- Fig. 5: ein Ablaufdiagramm eines Verfahrens zum Übertragen einer Information aus einer Batteriezelle gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

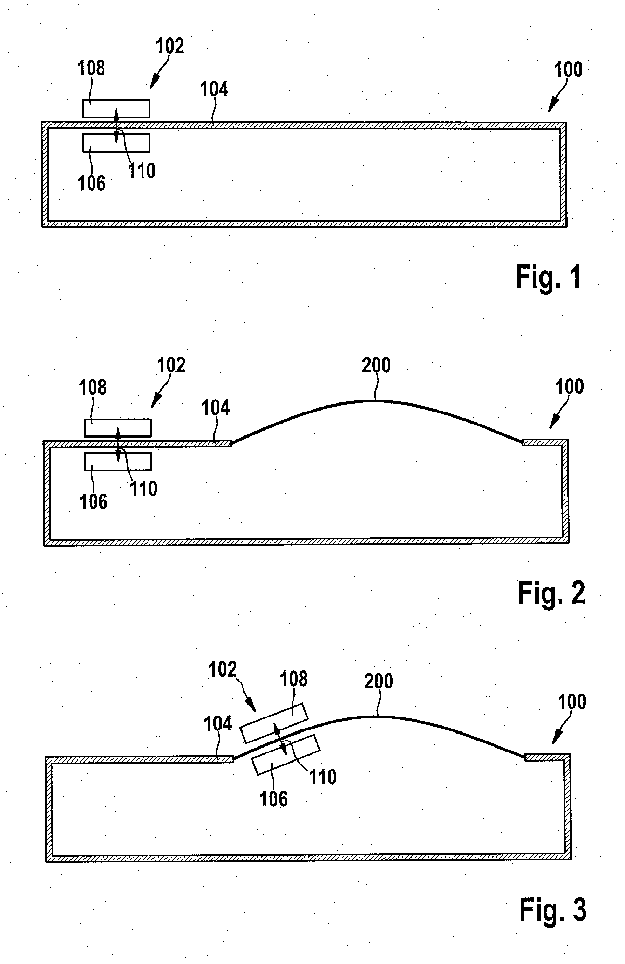

Fig. 1 zeigt eine Darstellung einer Batteriezelle 100 mit einer Vorrichtung zum Übertragen 102 einer Information gemäß einem Ausführungsbeispiel der vorliegenden Erfindung. Die Batteriezelle weist eine Außenhülle 104 mit einem beispielsweise rechteckigen Querschnitt auf.

Die Vorrichtung 102 weist einen ersten Übertrager 106 und einen zweiten Übertrager 108 auf. Der erste Übertrager 106 ist auf einer Innenseite einer Außenwand 104 der Batteriezelle 100 angeordnet. Der zweite Übertrager 108 ist dem ersten Übertrager 106 direkt gegenüberliegend auf einer Außenseite der Außenwand 104 angeordnet. In diesem Ausführungsbeispiel sind die Übertrager 106, 108 als flache plattenförmige Körper ausgebildet, die dicht an der Außenwand 104 der Batteriezelle 100 anliegen. Die Übertrager 106, 108 sind von der Außenwand 104 elektrisch isoliert. Die Übertrager 106, 108 sind voneinander galvanisch getrennt angeordnet. Die Übertrager 106, 108 sind dazu ausgebildet Signale 110 zu senden und zu empfangen. Die Signale 110 sind dazu ausgebildet, die Außenwand 104 zu durchdringen. Zumindest im Bereich der Übertrager 106, 108 ist die Außenwand 104 ohne Unterbrechung ausgeführt.

Fig. 2 zeigt eine Darstellung einer weiteren Batteriezelle 100 mit einer Vorrichtung zum Übertragen 102 einer Information gemäß einem weiteren Ausführungsbeispiel der vorliegenden Erfindung. Die Batteriezelle 100 und die Vorrichtung zum Übertragen 102 entspricht der Batteriezelle 100 in Fig. 1. Zusätzlich weist die Außenwand 104 der Batteriezelle 100 eine Aussparung auf, in der eine Berstmembran 200 angeordnet ist. Die Berstmembran 200 ist dünner als die übrige Außenwand 104 und ist dazu ausgebildet, die Batteriezelle 100 im Bereich der Aussparung zu begrenzen. Somit ist die Berstmembran 200 Teil der die Batteriezelle 100 umschließenden Außenhülle, die aus der Außenwand 104 und der Berstmembran 200 gebildet wird. Die Berstmembran 200 ist ausgebildet, um Volumenveränderungen eines Inhalts der Batteriezelle 100 durch elastische Verformungen auszugleichen. Wenn die Volumenveränderung zu groß ist, ist die Berstmembran 200 dazu ausgebildet zu zerreißen, um einen Überdruck in der Batteriezelle 100 abzubauen. Die Übertrager 106, 108 sind an der Außenwand 104 außerhalb der Berstmembran 200 angeordnet.

Fig. 3 zeigt eine Darstellung einer weiteren Batteriezelle 100 mit einer Vorrichtung zum Übertragen 102 einer Information gemäß einem weiteren Ausführungsbeispiel der vorliegenden Erfindung. Die Batteriezelle 100 entspricht der Batteriezelle 100 in Fig. 2. Im Gegensatz zu Fig. 2 ist die Vorrichtung zum Übertragen 102 im Bereich der Berstmembran 200 angeordnet. Damit ist die Berstmembran 200 zwischen dem ersten Übertrager 106 und dem zweiten Übertrager 108 angeordnet. Da die Berstmembran 200 dünner ist, als die übrige Außenwand 104, weist die Berstmembran 200 im Vergleich zu dem in Fig. 2 gezeigten Ausführungsbeispiel einen geringeren Widerstand für die zu übertragenden Signale 110 auf.

Die in den Figuren 1 und 2 gezeigten Ausführungsbeispiele können kombiniert werden. Beispielsweise kann die Batteriezelle 100 zwei Vorrichtungen zum Übertragen 102 aufweisen, wobei eine der Vorrichtung 102 im Bereich der Membran 200 und die andere der Vorrichtungen 102 im Bereich der Außenwand 104 angeordnet ist.

Anhand der Figuren 1 bis 3 werden im folgenden Ausführungsbeispiele der vorliegenden Erfindung näher beschrieben.

Die beiden Übertrager 106, 108 können an einer beliebigen Stelle der Wandung 104, 200 der Batteriezelle 100, also auch an der Berstmembran 200 der Batteriezelle 100 angeordnet werden.

Die Kopplung des Übertragers 106 auf der Innenseite der Zelle 100 und des Übertragers 108 auf der Außenseite der Zelle 100 kann entweder induktiv oder kapazitiv erfolgen. Bei kapazitiver Kopplung können die Übertrager 106, 108 als eine Platte eines Plattenkondensators ausgeformt sein.

Bei induktiver Kopplung können die Übertrager 106, 108 als Spule ausgeformt sein. Die Übertrager 106, 108 können entweder an einer beliebigen Stelle der Wandung 104 angebracht sein oder auf einer vorhandenen Berstmembran 200 angebracht sein. Die Kopplung kann entweder durch eine leitfähige Zellwandung 104 oder eine leitfähige Berstmembran 200, z. B. aus Metall wie Aluminium, erfolgen oder durch einen nicht leitfähigen Einsatz in der Zellwandung 104 oder durch eine nicht leitfähige Berstmembran 200 erfolgen. Als ein nicht leitfähiges Material kann z. B. Kunststoff eingesetzt werden.

Bei kapazitiver Übertragung durch die leitfähige Wandung 104 oder Membran 200 erfolgt die Übertragung durch Ladungsverschiebung. Der Übertrager 106, 108 auf einer Seite erzeugt mittels an ihn angelegter Spannung eine Ladungsverschiebung in der Wandung 104 oder der Membran 200, welche wiederum eine detektierbare Ladungsverschiebung im zweiten Übertrager 108, 106 hervorruft. Bei kapazitiver Kopplung durch eine nicht leitfähige Wandung 104 oder Membran 200 hindurch bilden der Übertrager 106 auf der Innenseite und der Übertrager 108 auf der Außenseite einen Plattenkondensator.

Bei induktiver Kopplung durch eine leitfähige Wandung 104 oder Membran 200 hindurch erzeugt ein Übertrager 106, 108 ein Magnetfeld und dadurch Wirbelströme oder ein Gegenfeld in der Wandung 104 oder Membran 200.

Dieses Gegenfeld wird vom zweiten Übertrager 106, 108 mittels einer Spule detektiert. Bei induktiver Kopplung durch eine nicht leitfähige Wandung 104 oder Membran 200 hindurch können die Spulen der beiden Übertrager 106, 108 eine direkte induktive Kopplung ausbilden.

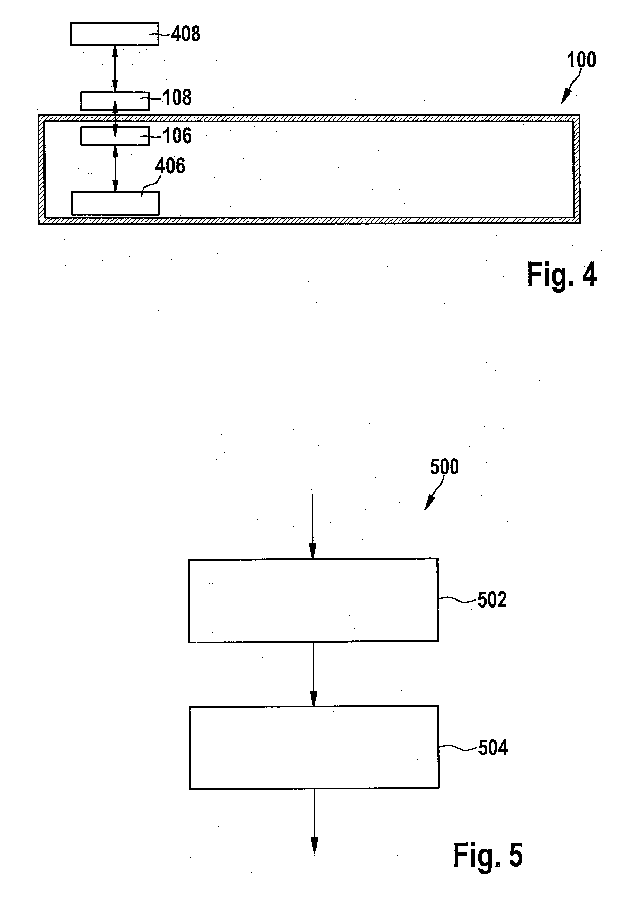

Fig. 4 zeigt eine Darstellung einer weiteren Batteriezelle 100 mit einer Vorrichtung zum Übertragen gemäß einem weiteren Ausführungsbeispiel der vorliegenden Erfindung. Die Vorrichtung zum Übertragen kann entsprechend der in den Figuren 1 bis 3 beschriebenen Ausführungsbeispiele ausgeführt und angeordnet sein. Die Batteriezelle 100 weist einen Sensor 406 auf, der im Inneren der Batteriezelle, in einem durch die Außenhülle der Batteriezelle 100 umschlossenen Bereich angeordnet ist. Der erste Übertrager 106 ist mit dem Sensor 406 gekoppelt, beispielsweise über eine elektrische Leitung. Der erste Übertrager 106 kann auch Teil des Sensors 406 sein, oder umgekehrt. Außerhalb der Batteriezelle 100 ist ein Steuergerät 408 angeordnet. Der zweite Übertrager 108 ist mit dem Steuergerät 408 gekoppelt, beispielsweise über eine elektrische Leitung.

Um eine Information von dem Sensor 406 an das Steuergerät 408 zu übertragen, ist der Sensor 406 ausgebildet, um die Information an den ersten Übertrager 106 zu übertragen. Der erste Übertrager 106 ist ausgebildet, um die Information unter Einsatz einer geeigneten Übertragungstechnik in ein Signal zu wandeln und das Signal an den zweiten Übertrager 108 auszusenden. Der zweite Übertrager 108 ist ausgebildet, um das Signal zu empfangen und direkt oder als mittels einer geeigneten Empfangstechnik aufbereiteten Informationssignals an das Steuergerät 408 auszugeben. Das Steuergerät 408 ist ausgebildet, um das von dem zweiten Übertrager 108 empfangene Signal oder das Informationssignal aufzubereiten, um die Information zu erhalten.

Um eine weitere Information von dem Steuergerät 408 an den Sensor 406 zu übertragen, ist das Steuergerät 408 ausgebildet, um die weitere Information an den zweiten Übertrager 108 zu übertragen. Der zweite Übertrager 108 ist ausgebildet, um die weitere Information unter Einsatz einer geeigneten Übertragungstechnik in ein weiteres Signal zu wandeln und das weitere Signal an den ersten Übertrager 106 auszusenden. Der erste Übertrager 106 ist ausgebildet, um das weitere Signal zu empfangen und direkt oder als mittels einer geeigneten Empfangstechnik aufbereiteten weiteren Informationssignals an den Sensor 406 auszugeben. Der Sensor 406 ist ausgebildet, um das von dem ersten Übertrager 106 empfangene weitere Signal oder das weitere Informationssignal aufzubereiten, um die weitere Information zu erhalten.

Durch das Übertragungsverfahren kann mittels induktiver oder kapazitiver Kopplung ein Sensorsignal 110 durch eine Batteriezellwandung an das Steuergerät 408 übertragen werden. Dadurch ist es nicht erforderlich, Werte für Spannung und Temperatur der Batteriezelle 100 durch extern applizierte Sensoren zu erfassen. Stattdessen kann ein intern applizierter Sensor 406 eingesetzt werden.

Durch die Übertrager 106, 108 können beispielsweise Messwerte, welche von dem zumindest einen innerhalb der Batteriezelle 100 platzierten Sensor 406 erfasst werden, durch die Wandung der Zelle 100 an das Steuergerät 408 gesendet werden. Dazu werden Daten mittels induktiver oder kapazitiver Übertrager 106, 108 durch die Zellwandung hindurch übertragen.

Durch den hier vorgestellten Ansatz kann der Sensor 406 innerhalb einer Batteriezelle 100 platziert werden, ohne dass eine (teure) Durchführung durch die Zellwand notwendig ist. Die Signale vieler Sensoren 406, die in einer oder in mehreren Batteriezellen angeordnet sind, können über eine einzige Leitung zum Steuergerät 408 geführt werden. Die Übertragung ist besonders verlustarm, wenn der Sensor 406 bereits aus anderen Gründen auf der Berstmembran angebracht ist.

Gemäß einem Ausführungsbeispiel können auf der Innenseite der Zelle 100 der Sensor 106 und der Übertrager 106 getrennte Bauelemente sein, welche z. B. durch Kabel oder Leiterbahnen auf einer gemeinsamen Platine verbunden sind. Alternativ können der Sensor 406 und der Übertrager 106 in einem Package oder sogar im gleichen Chip integriert sein. Auf der Außenseite kann der Übertrager 108 ein rein passives Bauelement sein, z. B. eine Spule oder eine Platte, welche an ein Kabel zum Steuergerät 408 angeschlossen ist. Auch kann ein aktives Element zwischen Übertrager 108 und Kabel angeordnet sein, um das Signal zu verstärken. Alternativ kann komplett auf ein explizites äußeres Übertragerbauteil verzichtet werden. In diesem Fall kann als Übertrager 108 lediglich ein Kabel an der entsprechenden Stelle über die Wandung oder Berstmembran geführt werden, in welches das Signal des Übertragers 406 direkt einkoppelt.

Bei Batterien mit mehreren Zellen 100 kann statt einzelner Kabel von jeder Zellaußenseite zum Steuergerät 408 auch ein einziges Kabel verwendet werden, welches vom Steuergerät 408 an allen Zellen 100 entlang führt und in welches die Signale aller Sensoren 406 einkoppeln. Dabei kann ein Übertragungsprotokoll eingesetzt werden, welches die parallele Übertragung auf einem einzigen Kabel zulässt, z. B. auf verschiedenen Trägerfrequenzen.

Gemäß einem Ausführungsbeispiel können demnach mehrere Batteriezellen 100 einem Steuergerät 408 zugeordnet sein. Jede Batteriezelle 100 weist jeweils zumindest einen Sensor 406 und zumindest einen Übertrager 106 auf. Ein mit dem Steuergerät 408 verbundenes elektrisch leitendes Kabel kann entlang der Außenseiten der mehreren Batteriezellen 100 geführt sein. An den einzelnen Batteriezellen 100 angeordnete Abschnitte des Kabels dienen jeweils als äußerer Übertrager 108. In diesem Fall sind die äußeren Übertrager 108 seriell miteinander verbunden.

Alternativ kann jede der mehreren Batteriezellen 100 einen separaten Übertrager 108 aufweisen, der über eine separate Leitung oder separate Übertragungsstrecke mit dem Steuergerät 408 verbunden ist.

Fig. 5 zeigt ein Ablaufdiagramm eines Verfahrens 500 zum Übertragen einer Information aus einer Batteriezelle gemäß einem Ausführungsbeispiel der vorliegenden Erfindung. Das Verfahren weist einen Schritt des Abgebens 502 und einen Schritt des Aufnehmens 504 auf. Das Verfahren 500 kann auf einer Vorrichtung, wie sie in den Figuren 1 bis 3 dargestellt ist ausgeführt werden.

Im Schritt des Abgebens 502 wird eine zu übertragende Information empfangen, ein die Information repräsentierendes Signal erzeugt, und mittels einem auf einer Seite einer Außenwand der Batteriezelle angeordneten Übertrager ausgesendet. Das Signal ist dazu ausgebildet, um die Außenwand zu durchdringen. Im Schritt des Aufnehmens 504 wird das Signal mittels einem auf der gegenüberliegenden Seite der Außenwand angeordneten weiteren Übertrager empfangen und zur weiteren Verarbeitung, beispielsweise an ein Steuergerät ausgegeben.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden.

## Patentansprüche

1. Batteriezelle (100) zum Speichern elektrischer Energie, wobei die Batteriezelle (100) die folgenden Merkmale aufweist:
eine Außenhülle (104; 200), die die Batteriezelle (100) umschließt; und
eine Vorrichtung (102) zum Übertragen einer Information aus der Batteriezelle (100), wobei
die Vorrichtung (102) die folgenden Merkmale aufweist:
einen ersten Übertrager (106), der auf einer Innenseite einer Außenhülle (104; 200) der Batteriezelle (100) angeordnet ist, wobei der erste Übertrager (106) dazu ausgebildet ist,
ein die Information repräsentierendes Signal (110) durch die Außenhülle (104; 200) der Batteriezelle (100) abzugeben; und
einen zweiten Übertrager (108), der auf einer Außenseite der Außenhülle (104; 200) der Batteriezelle (100) angeordnet ist und
galvanisch von dem ersten Übertrager (106) getrennt ist, wobei der zweite Übertrager (108) dazu ausgebildet ist,
das Signal (110) aufzunehmen,
wobei der zweite Übertrager (108) dazu ausgebildet ist,
ein eine weitere Information repräsentierendes, weiteres Signal (110) durch die Außenhülle (104; 200) der Batteriezelle (100) abzugeben, und
der erste Übertrager (106) dazu ausgebildet ist,
das weitere Signal (110) aufzunehmen,
wobei der erste Übertrager (106) unmittelbar an der Außenhülle (104; 200) der Batteriezelle (100) angeordnet ist und/oder der zweite Übertrager (108) unmittelbar an der Außenhülle (104; 200) der Batteriezelle (100) angeordnet ist
und der zweite Übertrager (108) dem ersten Übertrager (106) direkt gegenüberliegend auf der Außenseite der Außenhülle (104; 200) der Batteriezelle (100) angeordnet ist.

2. Batteriezelle (100) gemäß dem vorangegangenen Anspruch 1, wobei der erste Übertrager (106) einen auf die Außenhülle (104; 200) gerichteten ersten Übertragungsbereich aufweist, wobei der zweite Übertrager (108) innerhalb des ersten Übertragungsbereichs angeordnet ist und/oder der zweite Übertrager (108) einen auf die Außenhülle (104; 200) gerichteten zweiten Übertragungsbereich aufweist, wobei der erste Übertrager (106) innerhalb des zweiten Übertragungsbereichs angeordnet ist.

3. Batteriezelle (101) gemäß einem der vorangegangenen Ansprüche 1 bis 2, wobei der erste Übertrager (106) und der zweite Übertrager (108) je als ein induktiver Übertrager oder je als ein kapazitiver Übertrager ausgebildet sind.

4. Batteriezelle (100) gemäß einem der vorangegangenen Ansprüche 3, wobei die Außenhülle (104; 200) eine Berstmembran (200) aufweist, und wobei die Vorrichtung (102) im Bereich der Berstmembran (200) angeordnet ist.

5. Batteriezelle (100) gemäß einem der vorangegangenen Ansprüche, wobei die Außenhülle (104; 200) im Bereich der Vorrichtung (102) elektrisch isolierend ist.

6. Verfahren (500) zum Übertragen einer Information aus einer Batteriezelle (100) gemäß einem der Ansprüche 1 bis 5, wobei das Verfahren (500) die folgenden Schritte aufweist:
Abgeben (502) eines die Information repräsentierenden Signals (110) mittels einem auf einer Innenseite einer Außenhülle (104; 200) der Batteriezelle (100) angeordneten ersten Übertrager (106), wobei das Signal (110) dazu ausgebildet ist, um die Außenhülle (104; 200) zu durchdringen; und
Aufnehmen (504) des Signals (110) mittels einem auf einer Außenseite der Außenhülle (104; 200) angeordneten zweiten Übertragers (108).

## Claims

1. Battery cell (100) for storing electrical energy, wherein the battery cell (100) has the following features:
an outer shell (104; 200) which surrounds the battery cell (100); and
a device (102) for transmitting an information item from the battery cell (100), wherein
the device (102) has the following features:
a first transmitter (106) which is arranged on an inner side of an outer shell (104; 200) of the battery cell (100), wherein the first transmitter (106) is designed to emit a signal (110) representing the information item through the outer shell (104; 200) of the battery cell (100); and
a second transmitter (108) which is arranged on an outer side of the outer shell (104; 200) of the battery cell (100) and is galvanically isolated from the first transmitter (106), wherein the second transmitter (108) is designed to pick up the signal (110),
wherein the second transmitter (108) is designed to emit a further signal (110) representing a further information item through the outer shell (104; 200) of the battery cell (100), and the first transmitter (106) is designed to pick up the further signal (110),
wherein the first transmitter (106) is arranged directly on the outer shell (104; 200) of the battery cell (100) and/or the second transmitter (108) is arranged directly on the outer shell (104; 200) of the battery cell (100),
and the second transmitter (108) is arranged directly opposite the first transmitter (106) on the outer side of the outer shell (104; 200) of the battery cell (100).

2. Battery cell (100) according to the preceding Claim 1, wherein the first transmitter (106) has a first transmission region directed to the outer shell (104; 200), wherein the second transmitter (108) is arranged within the first transmission region and/or the second transmitter (108) has a second transmission region directed to the outer shell (104; 200), wherein the first transmitter (106) is arranged within the second transmission region.

3. Battery cell (101) according to one of the preceding Claims 1 to 2, wherein the first transmitter (106) and the second transmitter (108) are each formed as an inductive transmitter or as a capacitive transmitter.

4. Battery cell (100) according to one of the preceding Claims 3, wherein the outer shell (104; 200) has a rupture membrane (200), and wherein the device (102) is arranged in the region of the rupture membrane (200) .

5. Battery cell (100) according to one of the preceding claims, wherein the outer shell (104; 200) is electrically insulating in the region of the device (102) .

6. Method (500) for transmitting an information item from a battery cell (100) according to one of Claims 1 to 5, wherein the method (500) has the following steps:
emitting (502) a signal (110) representing the information item by means of a first transmitter (106) arranged on an inner side of an outer shell (104; 200) of the battery cell (100), wherein the signal (110) is designed to pass through the outer shell (104; 200); and
picking up (504) the signal (110) by means of a second transmitter (108) arranged on an outer side of the outer shell (104; 200).

## Revendications

1. Élément de batterie (100) destiné à stocker de l'énergie électrique, dans lequel l'élément de batterie (100) présente les caractéristiques suivantes :
une gaine extérieure (104 ; 200) renfermant l'élément de batterie (100) ; et
un dispositif (102) destiné à transmettre des informations provenant de l'élément de batterie (100), dans lequel
le dispositif (102) présente les éléments caractéristiques suivants :
un premier transmetteur (106) agencé sur un côté intérieur d'une gaine extérieure (104 ; 200) de l'élément de batterie (100), dans lequel
le premier transmetteur (106) est configuré pour émettre à travers la gaine extérieure (104 ; 200) de l'élément de batterie (100) un signal (110) représentant l'information ; et
un deuxième transmetteur (108) agencé sur un côté extérieur de la gaine extérieure (104 ; 200) de l'élément de batterie (100) et séparé galvaniquement du premier transmetteur (106), dans lequel le deuxième transmetteur (108) est configuré pour recevoir le signal (110),
dans lequel le deuxième transmetteur (108) est configuré pour émettre à travers la gaine extérieure (104 ; 200) de l'élément de batterie (100) un autre signal (110) représentant une autre information, et le premier transmetteur (106) est configuré pour recevoir l'autre signal (110),
dans lequel le premier transmetteur (106) est agencé directement sur la gaine extérieure (104 ; 200) de l'élément de batterie (100) et/ou le deuxième transmetteur (108) est agencé directement sur la gaine extérieure (104 ; 200) de l'élément de batterie (100) et le deuxième transmetteur (108) est agencé directement en face du premier transmetteur (106) sur le côté extérieur de la gaine extérieure (104 ; 200) de l'élément de batterie (100).

2. Élément de batterie (100) selon la revendication 1 précédente, dans lequel le premier transmetteur (106) présente une première zone de transmission dirigée vers la gaine extérieure (104 ; 200), dans lequel le deuxième transmetteur (108) est agencé à l'intérieur de la première zone de transmission et/ou le deuxième transmetteur (108) présente une deuxième zone de transmission dirigée vers la gaine extérieure (104 ; 200), dans lequel le premier transmetteur (106) est agencé à l'intérieur de la deuxième zone de transmission.

3. Élément de batterie (101) selon l'une des revendications 1 à 2 précédentes, dans lequel le premier transmetteur (106) et le deuxième transmetteur (108) sont chacun réalisés sous la forme d'un transmetteur inductif ou sous la forme d'un transmetteur capacitif.

4. Élément de batterie (100) selon l'une des revendications précédentes 3, dans lequel la gaine extérieure (104 ; 200) comprend une membrane de rupture (200), et dans lequel le dispositif (102) est agencé dans la zone de la membrane de rupture (200).

5. Élément de batterie (100) selon l'une des revendications précédentes, dans lequel la gaine extérieure (104 ; 200) est électriquement isolante dans la zone du dispositif (102).

6. Procédé (500) de transmission d'informations provenant d'un élément de batterie (100) selon l'une des revendications 1 à 5, dans lequel le procédé (500) comprend les étapes suivantes :
l'émission (502) d'un signal (110) représentant l'information au moyen d'un premier transmetteur (106) agencé sur un côté intérieur d'une gaine extérieure (104 ; 200) de l'élément de batterie (100), dans lequel le signal (110) est conçu pour pénétrer à travers la gaine extérieure (104 ; 200) ; et
la réception(504) du signal (110) au moyen d'un deuxième transmetteur (108) agencé sur un côté extérieur de la gaine extérieure (104 ; 200).
